(19) Europäisches Patentamt
European Patent Office
Office européen des brevets

(11) Publication number: **0 244 188 B1**

(12) **EUROPEAN PATENT SPECIFICATION**

(45) Date of publication of patent specification: **12.08.92**

(51) Int. Cl.5: **C08K 7/08**, C08L 81/02, H01B 3/30

(21) Application number: **87303709.7**

(22) Date of filing: **27.04.87**

(54) **Polyarylene thioether molding product.**

(30) Priority: **28.04.86 JP 98488/86**

(43) Date of publication of application:
**04.11.87 Bulletin 87/45**

(45) Publication of the grant of the patent:
**12.08.92 Bulletin 92/33**

(84) Designated Contracting States:
**DE FR GB**

(56) References cited:

**CHEMICAL ABSTRACTS, vol. 102, no. 20, 20th May 1985, page 46, abstrct no. 167775t, Columbus, Ohio, US; & JP-A-59 215 353**

(73) Proprietor: **KUREHA KAGAKU KOGYO KABUSHIKI KAISHA**
**9-11 Horidome-cho 1-chome Nihonbashi**
**Chuo-ku**
**Tokyo 103(JP)**

(72) Inventor: **Kouyama, Toshitaka**
**4-2-12 Nakaoka-machi**
**Iwaki-shi Fukushima-ken(JP)**
Inventor: **Iizuka, Yo**
**1-36-10 Iino Chuodai**
**Iwaki-shi Fukushima-ken(JP)**
Inventor: **Egawa, Harunobu**
**20 Sakaiidekura Nakoso-machi**
**Iwaki-shi Fukushima-ken(JP)**
Inventor: **Shiiki, Zenya**
**28-1 Ochiai Nishiki-machi**
**Iwaki-shi Fukushima-ken(JP)**

(74) Representative: **Woods, Geoffrey Corlett et al**
**J.A. KEMP & CO. 14 South Square Gray's Inn**
**London WC1R 5EU(GB)**

EP 0 244 188 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The present invention relates to a polyarylene thioether molding product and its use as a packaging material for electronic parts.

For electronic parts e.g., IC, LSI, transistor, diode and capacitor, resin encapsulation has generally been applied with the aim of conferring electrical insulation, providing mechanical protection and preventing changes in characteristics due to the external atmosphere.

The resin encapsulation has customarily been applied by way of a transfer molding process using a thermosetting resin such as epoxy resin, silicone resin and the like but, owing to the use of the thermosetting resin, this involves a drawback that the molding time is lengthy, storage and handling are difficult in view of the resins pot life and scraps such as spools and runners can not be re-used. For solving such problems, it has been attempted to use a polyarylene thioether (hereinafter simply referred to as PATE) which is a thermoplastic resin, but it is difficult, by the use of the PATE alone, to satisfy the both properties demanded for the packaging materials, which exhibit high flowability with no adherance to processing machines or the likes upon molding operation and provide packaging materials obtained therefrom with an excellent mechanical strength as well. Then, PATE molding product incorporated with glass fibers, glass beads, silica, etc, as a filler has been proposed (refer, for example, to Japanese Patent Publication No. 56-2790 (1981), as well as to Japanese Patent Application Laid-Open Nos. 53-22363 (1978), 55-22816 (1980) and 56-81953 (1981)). However, these PATE molding products involve a problem that if a sufficient amount of glass fibers or the likes is incorporated therein for obtaining a necessary mechanical strength, the melt viscosity is remarkably increased thereby causing shift of capacitor, IC, etc. elements or causing deformation or disconnection of bonding wires during packaging stage, as well as a problem that crackings are often caused due to the absence of soldering-resistance when the packaged electronic parts are heated at 260 °C for 10 sec.

For solving the problems in the conventional packaging materials, use of potassium titanate fibers smaller in diameter and shorter in length than conventional fillers has been proposed (refer, for example, to Japanese Patent Application Laid-open Nos. 59-20910 (1984), 59-20911 (1984) and 59-215353 (1984)). However, the potassium titanate fibers concretely used in Japanese Patent Application Laid-Open Nos. 59-20910 (1984), 59-20911 (1984) and 59-215353 (1984) have an average fiber diameter of from 0.2 to 0.5 $\mu$m and an average fiber length of from 10 to 20 $\mu$m and, if PATE is filled with a sufficient amount of the potassium titanate fibers of such a configuration, adhesion to metals thereof is abnormally increased and the obtained packaging materials are adhered to a screw and a cylinder upon melt molding and rotated integrally with them thereby making the molding impossible. If the amount of the potassium titanate fibers for filling is decreased in order to avoid such a drawback, it is difficult to obtain packaging materials having a satisfactory mechanical strength. Further, while the calcium silicate fibers (wollastonite) used in Japanese Patent Application Laid-Open Nos. 59-20910 (1984) and 59-20911 (1984) have a fiber diameter of 1 to 3 $\mu$m and a fiber length of about 20 $\mu$m and have been expected as a favorable filler for packaging materials in view of their configuration, no sufficient effect for improving the mechanical strength of the packaging materials is recognized due to the poor strength of the fibers per se.

Further, PATE used in the example of Japanese Patent Application Laid-Open No. 59-215353 (1984) is a crosslinked polymer showing a high melt viscosity. When such a crosslinked polymer showing the high melt viscosity is used, there is a problem of readily causing shift of the elements or deformation and disconnection of the bonding wires and often increasing the viscosity upon packaging, as well as a drawback that the packaging material thus obtained is extremely fragile in view of the mechanical strength.

The present inventors have made a study for overcoming the foregoing problems, as a result, found that a molding product in which potassium titanate fibers having an average fiber diameter of from 0.8 to 4.0 $\mu$m and an average fiber length of from 20 to 70 $\mu$m are incorporated into a substantially not-crosslinked PATE, exhibits a high flowability, does not adhere to processing machines upon molding processing and has a mechanical strength comparable with that of packaging materials obtained from conventional thermosetting resins, and have accomplished the present invention based on such a finding.

That is, a first object of the present invention is to provide a polyarylene thioether molding product not adhering to processing machines upon melt processing and having mechanical strength and soldering-resistance required in view of practical use.

Another object of the present invention is to provide soldering-resistant packaging materials comprising the molding product as described above for use in electronic parts.

In a first aspect of the present invention, there is provided a polyarylene thioether molding product having a melt viscosity of from 10 to 40 Pa s (measured at 310 °C under the shear rate of 10,000 $(sec)^{-1}$), a bending strength of not less than 10 $kg/mm^2$, a tensile strength of not less than 6 $kg/mm^2$ and an Izod

strength of not less than 7 kg•cm/cm, comprising 100 parts by weight of a substantially not-crosslinked polyarylene thioether having a melt viscosity of from 1 to 20 Pa s (measured at 310°C under the shear rate of 10,000 $(sec)^{-1}$) and from 40 to 250 parts by weight of potassium titanate fibers having an average fiber diameter of from 0.8 to 4.0 µm and an average fiber length of from 20 to 70 µm.

In a second aspect of the present invention, there is provided packaging materials for use in electronic parts, comprising a polyarylene thioether molding product having a melt viscosity of from 10 to 40 Pa s (measured at 310°C under the shear rate of 10,000 $(sec)^{-1}$), a bending strength of not less than 12 $kg/mm^2$, a tensile strength of not less than 7 $kg/mm^2$ and an Izod strength of not less than 8 kg•cm/cm, wherein said molding product comprises 100 parts by weight of a substantially not-crosslinked polyarylene thioether having a melt viscosity of from 1 to 20 Pa s (measured at 310°C under the shear rate of 10,000 $(sec)^{-1}$) and from 40 to 250 parts by weight of potassium titanate fibers having an average fiber diameter of from 0.8 to 4.0 µm and an average fiber length of from 20 to 70 µm.

Figure 1 shows a film capacitor element;

Figure 2 shows a state where the film capacitor element is normally packaged; and

Figure 3 is a schematic view showing the state where the film capacitor element shown in Figure 1 is packaged while undergoing shift upon packaging.

The present invention relates to a polyarylene thioether molding product comprising a substantially not-crosslinked polyarylene thioether having a melt viscosity of from 1 to 20 Pa s (measured at 310°C under the shear rate of 10,000 $(sec)^{-1}$) and potassium titanate fibers having an average fiber length of from 20 to 70 µm and an average fiber diameter of from 0.8 to 4 µm. The molding product according to the present invention does not adhere to the processing machines, particularly, upon melt processing, has mechanical strength and soldering-resistance required in view of practical use and is suitable as packaging materials for use in electronic parts.

Further, this invention also relates to soldering-resistant packaging materials for use in electronic parts comprising the above-mentioned molding product.

The PATE of the molding product according to the present invention is a polyarylene thioether which is polymerized substantially linearly.

In the present invention, PATE means a polymer having repeating units $\{Ar\text{-}S\}_n$ (where Ar represents an arylene group) as the main constituent.

The arylene group of PATE used in the present invention is preferably a paraphenylene group or a group comprising paraphenylene group as the main constituent in view of physical properties such as heat resistance, moldability and mechanical properties.

As an arylene group other than the paraphenylene group, for example, those having m-phenylene group

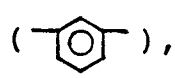

o-phenylene gorup

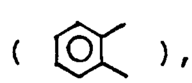

alkyl-substituted phenylene group

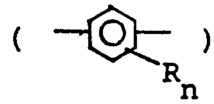

(where R represents an alkyl group, preferably, a lower alkyl group and n represents an integer of 1 to 4), p,p'-diphenylene-sulfonyl group

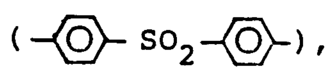

p,p'-biphenylene group

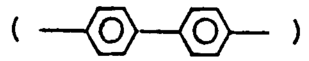,

p,p'-diphenylene ether group

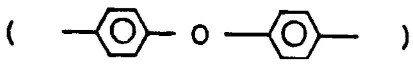,

p,p'-diphenylene carbonyl group

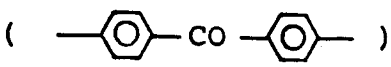

and naphthalene group

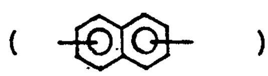

can be usable herein.

The melt viscosity of the PATE used in the present invention measured at 310 °C under the shear rate of 10,000 $(sec)^{-1}$ is from 1 to 20 Pa s and, preferably, from 2 to 15 Pa s. The molding product comprising PATE showing the melt viscosity of less than 1 Pa s is poor in melting workability, while the use of PATE showing the melt viscosity in excess of 20 Pa s is never desirable since the melt viscosity of the molding product is increased excessively thereby no more showing high flowability and causing disadvantage such as shift of elements or deformation and disconnection of bonding wires.

The PATE used in the present invention is preferably those of a substantially linear structure. Crosslinked PATE prepared by using an effective amount of a crosslinking agent (for instance, 1,2,4-trihalobenzene) upon polymerization, or a crosslinked PATE prepared by effectively crosslinking a linear polymer by high temperature treatment in the presence of $O_2$, etc, for instance, are not desired as the PATE in the present invention. The molding products obtained by using these crosslinked PATEs are undesirable not only in view of the workability due to the high melt viscosity upon processing but also in view of the physical properties of the obtained product since they are usually fragile extremely in the mechanical strength.

The above-mentioned linear PATE used in the present invention can be produced with an economical advantage, for example, by the process as disclosed in Japanese Patent Application Laid-Open No. 61-7332 (1986) filed by the present inventors. In addition, it is also possible to use, for example, a method of obtaining a high molecular weight linear PATE by adding a great amount of carboxylic acid to a polymerization system as disclosed in Japanese Patent Publication No. 52-12240 (1977).

The potassium titanate fibers used as the filler in the present invention are single crystal fibers represented by the general formula : $K_2O \cdot nTiO_2$ ($n \fallingdotseq 6$) having an average fiber diameter of from 0.8 to 4.0 µm, preferably, from 1.01 to 2.0 µm and an average fiber length of from 20 to 70 µm and, preferably, from 30 to 60 µm.

The molding product comprising potassium titanate fibers of less than 0.8 µm in average fiber diameter which are available up to now has remarkably increased adhesion to the metal surface, and is adhered to a cylinder, a screw and the like of the processing machine upon molding process thereby rotating integrally with them and making the molding impossible.

Further, if the filling amount of the potassium titanate fibers is decreased in order to reduce the adhesion, the mechanical strength of the molding product is also reduced thereby making the molding product not suitable to practical use.

While on the other hand, the PATE molding product obtained by using potassium titanate fibers having an average fiber diameter of more than 4.0 µm is insufficient in mechanical strength.

Further, in the case where the average fiber length of the potassium titanate fibers is less than 20 µm, it is difficult to obtain packaging materials of sufficient machanical strength. On the other hand, if it exceeds 70 µm, the melt viscosity of the molding product is remarkably increased to bring about disadvantages

such as shift of capacitors, etc. and deformation or disconnection of bonding wires of ICs and the like upon packaging. Further, in such a case, it is not practical since the industrial production of potassium titanate fibers over 70 $\mu$m in average fiber length is not easy.

That is, it is possible to obtain packaging materials showing a flowability suitable to packaging, that is, having a melt viscosity of from 10 to 40 Pa s and having a mechanical strength comparable with that of packaging materials obtained from conventional thermosetting resins as described later by the use of potassium titanate fibers having an average fiber diameter of from 0.8 to 4.0 $\mu$m and an average fiber length of from 20 to 70 $\mu$m as the filler for PATE.

The potassium titanate fibers used in the present invention can be incorporated without surface treatment thereof into the PATE or alternatively, it is also possible to use potassium titanate fibers surfaces of which have been treated with a silane coupling agent such as amino silane, alkoxy silane, epoxy silane, mercapto silane, acryl silane and the like, an organic titanate coupling agent or a fatty acid such as stearic acid. However, a surface treating agent with poor heat resistance or low boiling point is not desirable since they cause decomposition or foaming upon mixing under melt or molding processing thereby degrading the physical properties of the packaging materials. As the alkoxy silane, 3-glycidoxypropyltrimethoxysilane is preferred.

It is important that the sealers cause neither shift of capacitor, IC, etc. nor deformation and disconnection of bonding wires upon packaging. In view of the above, it is important that the packaging materials exhibit high flowability upon molding processing and it is necessary that the melt viscosity measured at 310°C under the shear rate of 10,000 $(sec)^{-1}$ is from 10 to 40 Pa s. If the melt viscosity of the molding product is less than 10 Pa s, it is not desirable since drawdown of the molding product is liable to be caused upon melting to bring about a difficulty of molding pellet or the like. On the other hand, the melt viscosity in excess of 40 Pa s is not favorable since the molding product shows no high flowability and possibly causes shift of the elements or deformation and disconnection of the bonding wires upon packaging.

Further, it is required for packaged electronic parts that they do not cause crackings or the likes due to stresses or temperature variations particularly upon soldering or in use. In view of the above, it is desirable that the molding product of the present invention has mechanical strength such as a bending strength of not less than 10 $kg/mm^2$, preferably, of not less than 12 $kg/mm^2$, a tensile strength of not less than 6 $kg/mm^2$ and, preferably, not less than 7 $kg/mm^2$ and an Izod strength of not less than 7 kg•cm/cm and, preferably, not less than 8 kg•cm/cm.

The molding product according to the present invention showing the melt viscosity and physical property as described above is obtained by filling the substantially not-crosslinked PATE as described above with from 40 to 250 parts by weight, preferably, from 55 to 190 parts by weight of the above-mentioned potassium titanate fibers based on 100 parts by weight of the substantially not-crosslinked PATE. If the filling amount of the potassium titanate fibers is less than 40 parts by weight, it is not desirable since the mechanical strength is insufficient. On the other hand, the filling amount in excess of 250 parts by weight is not favorable in view of the processing since the melt viscosity of the molding product is remarkably increased and shift of elements or deformation and disconnection of bonding wires are liable to occur upon packaging.

The molding product according to the present invention is usually obtained by a method of mixing under melting a substantially not-crosslinked PATE and potassium titanate fibers and forming them into a so-called "pellet". Alternatively, the molding product can also be obtained by dry-blending the powder of the both ingredients or pulverizing the above-mentioned pellets. Namely, the molding product according to the present invention may be obtained in desirable shape and size.

PATE is essentially a thermoplastic resin and, accordingly, various additives often employed in usual thermoplastic resins can be blended with the PATE molding product obtained according to the present invention. Specifically, the molding product can be prepared by mixing under melting with powdery inorganic fillers such as mica, $TiO_2$, $SiO_2$, $Al_2O_3$, $CaCO_3$, carbon black, talc, $Ca_2SiO_4$, $MgCO_3$, glass and the like. Furthermore, the molding product of the present invention can also be prepared by blending with fillers comprising organic high molecular material such as PE rubber, polyisobutylene, hydrogenated SBS rubber, fluororubber, polyester elastomer, polyimide, polyamide, polyetherether ketone, polysulfone, polyether sulfone, polyether imide, polyarylene, polyphenylene ether, polycarbonate, polyethylene terephthalate, polybutylene terephthalate, polyacetal, polypropylene, polyethylene, ABS, polyvinyl chloride, polymethylmethacrylate, polystyrene, polyvinylidene fluoride, polytetrafluoroethylene, tetrafluoroethylene copolymer and the like. In addition to these fillers, it is also possible to use a small amount of stabilizer, nucleating agent, lubricant, rust preventive, coupling agent, release agent, water repellant, antioxidant, pigment, etc.

Accordingly, the molding product according to the present invention may include those molding products blended with various kind of additives as described above in addition to those molding products comprising only the PATE and the potassium titanate fibers.

The molding product according to the present invention is desirably molded by way of usual molding process, that is, injection molding, compression molding and extrusion molding in which particularly, the injection molding is preferable, and the thus obtained molding product preferably has mechanical strength such as a bending strength of not less than 10 $kg/mm^2$ and, preferably, not less than 12 $kg/mm^2$, a tensile strength of not less than 6 $kg/mm^2$ and, preferably, not less than 7 $kg/mm^2$ and an Izod strength of not less than 7 kg•cm/cm and, preferably, not less than 8 kg•cm/cm, as well as excellent soldering-resistance (no substantial occurrence of cracking is recognized when immersed in a soldering bath at 260°C for 10 sec).

Accordingly, the molding product according to the present invention is preferably used for packaging electronic parts, for example, capacitor, IC, LSI, transistor, diode, etc. particularly, capacitor elements.

The molding product according to the present invention, due to its low melt viscosity, causes scarcely shift of elements and deformation or disconnection of bonding wires upon packaging of electronic parts such as capacitor, IC, etc. and has mechanical strength comparable with that of molding products using conventional thermosetting resin such as epoxy resin.

Further, according to the molding product of the present invention, it is possible to solve the problems in the conventional thermosetting resin molding products, that is, long molding time, difficulty in the storage caused by the pot life and difficulty in the re-use of scraps, etc. and further, it is possible to reduce the high adhesion of the molding products proposed up to now composed of PATE and potassium titanate fibers to metals thereby improving the productivity upon molding processing.

Further, the packaged electronic parts obtained from the molding product according to the present invention has excellent mechanical strength and soldering-resistance.

The present invention will now be described more in details referring to examples, but the invention is no way limited only to these examples.

## Example 1

### Preparation of Polyarylene thioether (PATE)

Into a 2 $m^3$ volume titanium-lined autoclave, 1000 kg of N-methylpyrrolidone and 2.2 kmol of sodium sulfide (45.93 % of solid content) were charged and the temperature was elevated to about 200°C to distill the water. Then, 2.45 kmol of p-dichlorobenzene and 250 kg of N-methylpyrrolidone were charged thereto and brought into reaction at 210°C for 2 hours and, further, at 220°C for 4 hours. Then, 7.45 kmol of purified water were added and the reaction was further carried out at 263°C for 1.5 hours. After the reaction was over, the reaction mixture was filtered by using a screen, washed with an aqueous 1.2 % ammonium chloride solution at 50°C for several times, washed with water, dehydrated and dried to obtain PATE. The melt viscosity of the thus obtained PATE (hereinafter referred to as polymer A) was 4 Pa s (measured at 310°C under the shear rate of 10,000 $(sec)^{-1}$).

### Preparation of polyarylene thioether molding product

After blending 40 parts by weight of the polymer A, 60 parts by weight of potassium titanate fibers A described in Table 1 as the inorganic filler, 0.1 parts by weight of calcium hydroxide and 0.1 parts by weight of 3-glycidoxypropyltrimethoxysilane in a mixer, they were mixed under melting by using a twin-screw extruder of the same direction rotation type to obtain a pellet-like PATE molding product. The melt viscosity of the thus obtained PATE molding product was 17 Pa s (measured at 310°C under shear rate of 10,000 $(sec)^{-1}$).

### Bending test, tensile test and Izod impact test

Specimens for the bending test, tensile test and Izod impact test were respectively molded under the conditions shown below by using the pellet-like PATE molding product obtained as described above.

The tests were carried out according to ASTM D-790 for the bending test, ASTM D-638 for the tensile test and ASTM D-256 for the Izod impact test (with no notch).

The results of the each test are shown in Table 2.

| Molding machine: Injection molding machine (JT-40S) manufactured by Nippon Seikosho | |
|---|---|
| Molding conditions | |
| Cylinder temperature<br>Die temperature<br>Number of screw rotation<br>Injection pressure<br>Pressure maintained<br>Injection time | 300 - 325 - 310 ° C<br>135 ° C<br>150 - 200 rpm<br>1100 - 1200 kg/cm$^2$<br>30 - 90 kg/cm$^2$<br>5 sec |

Packaging test and soldering-resistant test

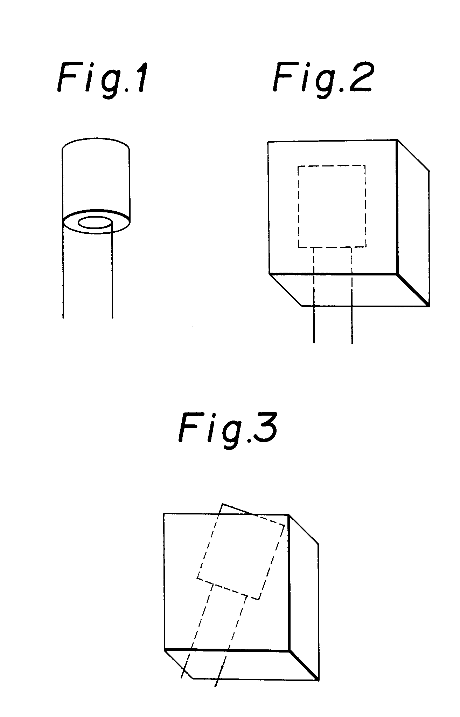

A capacitor element made of heat-resistant polyphenylene thioether film (shown in Figure 1) was packaged under the following conditions by using the pellet-like PATE molding product obtained as described above to obtain a packaged molding product.

The capacitor element could be sealed normally as shown in Figure 2 and any of shift of the element as shown in Figure 3, disconnection of bonding wire, cracking and the like was not recognized.

| Packaging molding machine: Injection molding machine (JT-40S) manufactured by Nippon Seikosho | |
|---|---|
| Cylinder temperature<br>Die temperature<br>Number of screw rotation:<br>Injection pressure<br>Pressure maintained<br>Injection time<br>Cooling time | 270 - 310 - 310 ° C<br>150 ° C<br>150 rpm<br>750 kg/cm$^2$<br>80 kg/cm$^2$<br>5 sec<br>5 sec |

Soldering-resistance test was conducted for the packaged molding product obtained as described above.

After immersing the packaged molding product in a soldering bath at 260 ° C for 10 sec, presence or absence of crackings was observed resulting in finding no occurrence of crackings.

Examples 2 and 3

Pellet-like PATE molding products having melt viscosity of 15 Pa s and 22 Pa s respectively were obtained in the same procedures as in Example 1 excepting for mixing the PATE (polymer A) and the above-mentioned potassium titanate fibers A at the mixing rates described in Table 2.

Further, bending test, tensile test, Izod impact test, packaging test and soldering-resistant test were conducted respectively by using each of the pellet-like PATE molding products as in Example 1.

The results are shown in Table 2.

Comparative Example 1

PATE (hereinafter referred to as polymer B) showing the melt viscosity of 26 Pa s (measured at 310 ° C under the shear rate of 10,000 (sec)$^{-1}$) was obtained in the same procedures as in Example 1 excepting for charging 2.27 kmol of p-dichlorobenzene.

A pellet-like PATE molding product was obtained in the same procedures as in Example 1 by using 70 parts by weight of the polymer B, 30 parts by weight of the above mentioned potassium titanate fibers A, 0.1 parts by weight of calcium hydroxide and 0.1 parts by weight of 3-glycidoxypropyltrimethoxysilane.

The melt viscosity of the obtained PATE molding product (measured at 310 ° C under the shear rate of 10,000 (sec)$^{-1}$) was 65 Pa s.

The bending test, the tensile test, the Izod impact test, the capacitor packaging test and the soldering-resistant test were conducted in the same procedures as in Example 1 by using the pellet-like PATE molding product as described above. The results are shown in Table 2.

Comparative Example 2

Into a 2 $m^3$ volume titanium-lined autoclave, 1000 kg of N-methylpyrrolidone and 2.2 kmol of sodium sulfide (45.93 % of solid content) were charged and the temperature was elevated to about 200 °C to distill the water. Then, 2.45 kmol of p-dichlorobenzene and 250 kg of N-methylpyrrolidone were charged and brought into reaction at 210 °C for 2 hours and, further, at 220 °C for 4 hours. After the reaction was over, the reaction mixture was filtered by using a screen, washed with an aqueous 1.2 % ammonium chloride solution at 50 °C for several times, washed with water, dehydrated and dried to obtain PATE. The melt viscosity of the thus obtained PATE (hereinafter referred to as polymer C) was 0,2 Pa s (measured at 310 °C under the shear rate of 10,000 $(sec)^{-1}$).

It was tried to prepare a pellet-like PATE molding product by mixing under melting 30 parts by weight of the polymer C, 70 parts by weight of the above-mentioned potassium titanate fibers A, 0.1 parts by weight of calcium hydroxide and 0.1 parts by weight of 3-glycidoxypropyltrimethoxysilane in the same procedures as in Example 1, but since remarkable drawdown occurred thereby making the pelletization difficult, a PATE molding product was obtained in the form of a lump. The melt viscosity thereof was 3,5 Pa s (measured at 310 °C under a shear rate of 10,000 $(sec)^{-1}$).

After pulverizing the lump PATE molding product described above, it was tried to obtain respective test specimens and capacitor packaging molding products by the same way as in Example 1. However, since the products were extremely fragile, they were broken upon taking out them from the molding machine resulting in failing to obtain normal molding product.

Comparative Examples 3 - 17

Each of the PATE molding products was prepared in the same procedures as in Example 1 excepting for mixing the polymer A obtained in Example 1 and the fillers shown in Table 1 at the mixing ratios described in Table 2 and each of the tests was conducted. The results are shown in Table 2.

Table 1

| Inorganic Filler | | | |
|---|---|---|---|
| Kind of filler | Average size | | Manufacturer (trade name of filler) |
| | diameter | length | |
| Potassium titanate fibers A | 1.1 µm | 55 µm | Titan Kogyo K.K. (HT-200) |
| Potassium titanate fibers B | 0.4 µm | 13 µm | Otsuka Kagaku K.K. (TISMO-D) |
| Glass fibers A | 6 µm | 3 mm | Asahi Fiber Glass K.K. (03DE404) |
| Glass fibers B | 6 µm | 3 mm | Nitto Boseki K.K. |
| Calcium silicate fibers (wollastonite) | 2.0 µm | 20 µm | NYCO K.K. (NYAD-G) |
| Silica beads | 9.5 µm | - | Denki Kagaku K.K. (FS44) |
| Note: Values for glass fibers are according to those described in catalogs and values for other fibers are according to those determined by the electron microscopy. | | | |

Table 2

| | Composition (part by weight) | | | | | | | | | Melt viscosity (Pa s) | Bending property | | Tensile property | | | Izod | Packaged Product | |
|---|---|---|---|---|---|---|---|---|---|---|---|---|---|---|---|---|---|---|
| | PATE | | | Inorganic filler | | | | | | | | | | | | | | |
| | | | | Potassium titanate fiber | | Glass fiber | | Calcium silicate fiber | Silica beads | | strength ($kg/mm^2$) | modulus of elasticity ($kg/mm^2$) | Strength ($kg/mm^2$) | elongation (%) | modulus of elasticity ($kg/mm^2$) | Strength (with no notch) (kg·cm/cm) | Shift of element (*1) | soldering-resistance (*2) |
| | A | B | C | A | B | A | B | | | | | | | | | | | |
| Example 1 | 40 | | | 60 | | | | | | 17 | 14.7 | 2661 | 7.8 | 0.30 | 2382 | 9.3 | A | A |
| 2 | 45 | | | 55 | | | | | | 15 | 13.9 | 2350 | 7.6 | 0.38 | 1845 | 8.2 | A | A |
| 3 | 35 | | | 65 | | | | | | 22 | 15.1 | 2840 | 8.0 | 0.28 | 2560 | 9.9 | A | A |
| Comparative Example 1 | | 70 | | 30 | | | | | | 65 | 7.8 | 1850 | 6.0 | 0.80 | 850 | 9.9 | C | C |
| 2 (*3) | | | 30 | 70 | | | | | | 35 | - | - | - | - | - | - | - | - |
| 3 | 60 | | | | 40 | | | | | 9 | 11.9 | 1777 | 4.3 | 0.27 | 1297 | 3.3 | A | B |
| 4 | 50 | | | | 50 | | | | | 13 | 11.0 | 2249 | 4.4 | 0.24 | 1395 | 4.1 | A | C |
| 5 (*3) | 40 | | | | 60 | | | | | 23 | - | - | - | - | - | - | - | - |
| 6 | 60 | | | 40 | | | | | | 8 | 10.0 | 1684 | 4.1 | 0.27 | 1161 | 3.6 | A | C |

Table 2 (Cont.)

| | Composition (part by weight) | | | | | | | | | Melt visco-sity (poise) | Bending property | | Tensile property | | | Izod Strength (with no notch) (kg·cm/cm) | Packaged Product | |
|---|---|---|---|---|---|---|---|---|---|---|---|---|---|---|---|---|---|---|
| | PATE | | | Inorganic filler | | | | | | | strength (kg/mm2) | modulus of elasti-city (kg/mm2) | Strength (kg/mm2) | elonga-tion (%) | modulus of elasti-city (kg/mm2) | | Shift of ele-ment (*1) | solder-ing-re-sistance (*2) |
| | A | B | C | Potas-sium ti-tanate fiber A | Potas-sium ti-tanate fiber B | Glass fiber A | Glass fiber B | Calcium silicate fiber | Silica beads | | | | | | | | | |
| Com-parative Ex-ample | | | | | | | | | | | | | | | | | | |
| 7 | 40 | | | | 30 | | | | 30 | 330 | 8.1 | 1858 | 4.6 | 0.29 | 1354 | 2.8 | B | C |
| 8 | 40 | | | | 40 | | | | 20 | 180 | 7.2 | 1575 | 4.0 | 0.28 | 1293 | 3.3 | A | C |
| 9 | 40 | | | 40 | | | | | 20 | 250 | 9.1 | 1855 | 5.8 | 0.31 | 1682 | 5.4 | A | C |
| 10 | 40 | | | 20 | | 20 | | | 20 | 240 | 9.1 | 1653 | 6.4 | 0.41 | 1563 | 5.8 | A | C |
| 11 | 40 | | | | 20 | 20 | | | 20 | 240 | 9.1 | 1619 | 5.8 | 0.33 | 1574 | 4.8 | A | C |
| 12 | 40 | | | | | | 60 | | | 230 | 12.0 | 2099 | 8.4 | 0.38 | 1679 | 7.2 | A | B |
| 13 | 35 | | | | | 40 | | | 25 | 350 | 10.0 | 1892 | 5.91 | 0.35 | 1521 | 6.4 | B | C |
| 14(*3) | 30 | | | | | | 50 | | 20 | 860 | - | - | - | - | - | - | - | - |
| 15 | 40 | | | | | | | 60 | | 150 | 9.2 | 2320 | 3.5 | 0.23 | 1496 | 4.1 | A | C |
| 16 | 40 | | | | | | | 40 | 20 | 180 | 7.0 | 1809 | 3.8 | 0.19 | 1783 | 4.0 | A | C |
| 17 | 40 | | | | | 20 | | 20 | 20 | 220 | 8.9 | 1755 | 5.0 | 0.28 | 1764 | 4.9 | A | C |

Notes (*1) A : no substantial occurrence, B : slight occurrunce, C : frequent occurrence
(*2) A : no substantial occurrence of crackings, B : slight occurrence of crackings, C : frequent occurrence of crackings
(*3) Measurement impossible because of difficult molding

## Claims

1. A polyarylene thioether molding product having a melt viscosity of from 10 to 40 Pa s (100 to 400 poise) (measured at 310 ° C under the shear rate of 10,000 $(sec)^{-1}$), a bending strength of not less than 10 $kg/mm^2$, a tensile strength of not less than 6 $kg/mm^2$ and an Izod strength of not less than 7

kg.cm/cm, which product comprises 100 parts by weight of a substantially uncrosslinked polyarylene thioether having a melt viscosity of from 1 to 20 Pa s (10 to 200 poise) (measured at 310°C under the shear rate of 10,000 $(sec)^{-1}$) and from 40 to 250 parts by weight of potassium titanate fibers having an average fiber diameter of from 0.8 to 4.0 µm and an average fiber length of from 20 to 70 µm.

**2.** A polyarylene thioether molding product according to claim 1, wherein the arylene component of the said substantially uncrosslinked polyarylene thioether is a paraphenylene group or comprises a paraphenylene group as a main constituent.

**3.** A polyarylene thioether molding product according to claim 1 or 2, wherein the melt viscosity of the said substantially uncrosslinked polyarylene thioether is from 2 to 15 Pa s (20 to 150 poise) (measured at 310°C under the shear rate of 10,000 $(sec)^{-1}$).

**4.** A polyarylene thioether molding product according to any one of the preceding claims, wherein the said potassium titanate fibers have an average fiber diameter of from 1.01 to 2.0 µm and an average fiber length of from 30 to 60 µm.

**5.** A polyarylene thioether molding product according to any one of the preceding claims, wherein the surface of said potassium titanate fibers has been treated with a silane coupling agent, organic titanate coupling agent or fatty acid.

**6.** A polyarylene thioether molding product according to claim 5, wherein the said silane coupling agent is an aminosilane, alkoxy silane, epoxy silane, mercapto silane or acryl silane.

**7.** A polyarylene thioether molding product according to claim 6, wherein the said alkoxy silane is 3-glycidoxypropyltrimethoxysilane.

**8.** A polyarylene thioether molding product according to claim 5, wherein the said fatty acid is stearic acid.

**9.** A polyarylene thioether molding product according to any one of the preceding claims which comprises 100 parts by weight of the said substantially uncrosslinked polyarylene thioether and from 55 to 190 parts by weight of said potassium titanate fibers.

**10.** A polyarylene thioether molding product according to any one of the preceding claims, which further comprises a powdery inorganic filler.

**11.** A polyarylene thioether molding product according to claim 10, wherein the said powdery inorganic filler is mica, $TiO_2$, $SiO_2$, $Al_2O_3$, $CaCO_3$, carbon black, talc, $Ca_2SiO_4$, $MgCO_3$ or glass.

**12.** A polyarylene thioether molding product according to any one of the preceding claims, which further comprises a high molecular weight organic filler material.

**13.** A polyarylene thioether molding product according to claim 12, wherein the said high molecular weight organic filler material is PE rubber, polyisobutylene, hydrogenated SBS rubber, fluororubber, polyester elastomer, polyimide, polyamide, polyether-ether ketone, polysulfone, polyether sulfone, polyether imide, polyarylene, polyphenylene ether, polycarbonate, polyethylene terephthalate, polybutylene terephthalate, polyacetal, polypropylene, polyethylene, ABS, polyvinyl chloride, polymethyl methacrylate, polystyrene, polyvinylidene fluoride, polytetrafluoroethylene or tetrafluoroethylene copolymer.

**14.** Use as a packaging material for an electronic part of a polyarylene thioether molding product as claimed in any one of the preceding claims.

**15.** Use according to claim 14, wherein the polyarylene thioether molding product has a bending strength of not less than 12 $kg/mm^2$, a tensile strength of not less than 7 $kg/mm^2$ and an Izod strength of not less than 8 kg.cm/cm.

16. Use according to claim 14 or 15, wherein the said electronic part is a capacitor, IC, LSI, transistor or diode element.

17. Use according to claim 16, wherein the said electronic part is a capacitor element.

**Revendications**

1. Produit de moulage en thioéther de polyarylène ayant une viscosité à l'état fondu allant de 10 à 40 Pa.s (100 à 400 poises) (mesurée à 310 °C à une vitesse de cisaillement de 10 000 $(sec)^{-1}$), une résistance à la flexion d'au moins 10 $kg/mm^2$, une résistance à la traction d'au moins 6 $kg/mm^2$ et une résistance Izod d'au moins 7 kg.cm/cm, lequel produit comprend 100 parties en poids d'un thioéther de polyarylène sensiblement non réticulé ayant une viscosité à l'état fondu allant de 1 à 20 Pa.s (10 à 200 poise) (mesurée à 310 °C à une vitesse de cisaillement de 10 000 $(sec)^{-1}$) et de 40 à 250 parties en poids de fibres de titanate de potassium ayant un diamètre de fibres moyen allant de 0,8 à 4,0 µm et une longueur de fibre moyenne de 20 à 70 µm.

2. Produit de moulage en thioéther de polyarylène selon la revendication 1, dans lequel le composant arylène dudit thioéther de polyarylène sensiblement non réticulé est un groupe paraphénylène ou comprend un groupe paraphénylène comme principal constituant.

3. Produit de moulage en thioéther de polyarylène selon la revendication 1 ou 2, dans lequel la viscosité à l'état fondu dudit thioéther de polyarylène sensiblement non réticulé est de 2 à 15 Pa.s (20 à 150 poises) (mesurée à 310 °C à une vitesse de cisaillement de 10 000 $(sec)^{-1}$).

4. Produit de moulage en thioéther de polyarylène selon l'une quelconque des revendications précédentes, dans lequel lesdites fibres de titanate de potassium ont un diamètre de fibre moyen allant de 1,01 à 2,0 µm et une longueur de fibre moyenne allant de 30 à 60 µm.

5. Produit de moulage en thioéther de polyarylène selon l'une quelconque des revendications précédentes, dans lequel la surface desdites fibres de titanate de potassium a été traitée avec un agent de couplage à base de silane, un agent de couplage à base de titanate organique ou un acide gras.

6. Produit de moulage en thioéther de polyarylène selon la revendication 5, dans lequel ledit agent de couplage à base de silane est un aminosilane, un alcoxy-silane, un époxy-silane, un mercapto-silane ou un acrylo-silane.

7. Produit de moulage en thioéther de polyarylène selon la revendication 6, dans lequel ledit alcoxy-silane est le 3-glycidoxypropyltriméthoxysilane.

8. Produit de moulage en thioéther de polyarylène selon la revendication 5, dans lequel ledit acide gras est l'acide stéarique.

9. Produit de moulage en thioéther de polyarylène selon l'une quelconque des revendications précédentes, qui comprend 100 parties en poids dudit thioéther de polyarylène sensiblement non réticulé et de 55 à 190 parties en poids desdites fibres de titanate de potassium.

10. Produit de moulage en thioéther de polyarylène selon l'une quelconque des revendications précédentes, qui comprend en outre une charge inorganique pulvérulente.

11. Produit de moulage en thioéther de polyarylène selon la revendication 10, dans lequel ladite charge inorganique pulvérulente est le mica, $TiO_2$, $SiO_2$, $Al_2O_3$, $CaCO_3$, le noir de fumée, le talc, $Ca_2SiO_4$, $MgCO_3$ ou le verre.

12. Produit de moulage en thioéther de polyarylène selon l'une quelconque des revendications précédentes, qui comprend en outre une charge organique à haut poids moléculaire.

13. Produit de moulage en thioéther de polyarylène selon la revendication 12, dans lequel ladite charge organique à haut poids moléculaire est le caoutchouc PE, le polyisobutylène, le caoutchouc SBS

hydrogéné, le fluorocaoutchouc, un élastomère de polyester, un polyimide, un polyamide, une polyéther-éther-cétone, une polysulfone, une polyéther-sulfone, un polyéther-imide, un polyarylène, un éther de polyphénylène, un polycarbonate, le téréphtalate de polyéthylène, le téréphtalate de polybutylène, le polyacétal, le polypropylène, le polyéthylène, l'ABS, le chlorure de polyvinyle, le méthacrylate de polyméthyle, le polystyrène, le fluorure de polyvinylidène, le polytétrafluoréthylène ou un copolymère de tétrafluoroéthylène.

**14.** Application comme matériau d'emballage pour une pièce électronique d'un produit de moulage en thioéther de polyarylène selon l'une quelconque des revendications précédentes.

**15.** Application selon la revendication 14, dans laquelle le produit de moulage en thioéther de polyarylène a une résistance à la flexion d'au moins 12 kg/mm$^2$, une résistance à la traction d'au moins 7 kg/mm$^2$ et une résistance Izod d'au moins 8 kg.cm/cm.

**16.** Application selon la revendication 14 ou 15, dans laquelle ladite pièce électronique est un capaciteur, un circuit intégré, un microcircuit, un transistor ou un élément de diode.

**17.** Application selon la revendication 16, dans laquelle ladite pièce électronique est un élément de capaciteur.

**Patentansprüche**

**1.** Polyarylenthioetherformprodukt mit einer Schmelzviskosität von 10 bis 40 Pa s (100 bis 400 Poise) (gemessen bei 310 °C unter der Scherr-Rate von 10000 s$^{-1}$), einer Biegefestigkeit von nicht weniger als 10 kg/mm$^2$, einer Zugfestigkeit von nicht weniger als 6 kg/mm$^2$ und einer Izod-Stärke von nicht weniger als 7 kg x cm/cm, wobei das Produkt umfaßt: 100 Gewichtsteile eines im wesentlichen unvernetzten Polyarylenthioethers mit einer Schmelzviskosität von 1 bis 20 Pa s (10 bis 200 Poise) (gemessen bei 310 °C unter der Scherr-Rate von 10.000 s$^{-1}$) und von 40 bis 250 Gew.Teilen Kaliumtitanatfasern mit einem durchschnittlichen Faserdurchmesser von 0,8 bis 4,0 $\mu$m und einer durchschnittlichen Faserlänge von 20 bis 70 $\mu$m.

**2.** Polyarylenthioetherformprodukt nach Anspruch 1,
dadurch **gekennzeichnet,** daß die Arylenkomponente des im wesentlichen unvernetzten Polyarylenthioethers eine Paraphenylengruppe ist oder eine Paraphenylengruppe als einen Hauptbestandteil enthält.

**3.** Polyarylenthioetherformprodukt nach Anspruch 1 oder 2,
dadurch **gekennzeichnet,** daß die Schmelzviskosität des im wesentlichen unvernetzten Polyarylenthioethers von 2 bis 15 Pa s (20 bis 150 Poise) (gemessen bei 310 °C unter der Scherr-Rate von 10.000 s$^{-1}$) ist.

**4.** Polyarylenthioetherformprodukt nach einem der vorhergehenden Ansprüche,
dadurch **gekennzeichnet,** daß die Kaliumtitanatfasern einen durchschnittlichen Faserdurchmesser von 1,01 bis 2,0 $\mu$m und eine durchschnittliche Faserlänge von 30 bis 60 $\mu$m aufweisen.

**5.** Polyarylenthioetherformprodukt nach einem der vorhergehenden Ansprüche,
dadurch **gekennzeichnet,** daß die Oberfläche der Kaliumtitanatfasern mit einem Silankupplungsmittel, einem organischen Titanatkupplungsmittel oder Fettsäure behandelt worden ist.

**6.** Polyarylenthioetherformprodukt nach Anspruch 5,
dadurch **gekennzeichnet,** daß das Silankupplungsmittel Aminosilan, Alkoxysilan, Epoxysilan, Mercaptosilan oder Acrylsilan ist.

**7.** Polyarylenthioetherformprodukt nach Anspruch 6,
dadurch **gekennzeichnet,** daß das Alkoxysilan 3-Glycidoxypropyltrimethoxysilan ist.

**8.** Polyarylenthioetherformprodukt nach Anspruch 5,
dadurch **gekennzeichnet,** daß die Fettsäure Stearinsäure ist.

**9.** Polyarylenthioetherformprodukt nach einem der vorhergehenden Ansprüche, dadurch **gekennzeichnet,** daß es 100 Gew.Teile des im wesentlichen unvernetzten Polyarylenthioethers und 55 bis 190 Gew.Teile der Kaliumtitanatfasern enthält.

**10.** Polyarylenthioetherformprodukt nach einem der vorhergehenden Ansprüche, dadurch **gekennzeichnet,** daß es weiterhin einen pulverförmigen anorganischen Füllstoff enthält.

**11.** Polyarylenthioetherformprodukt nach Anspruch 10, dadurch **gekennzeichnet,** daß der pulverförmige anorganische Füllstoff Mica, $TiO_2$, $SiO_2$, $Al_2O_3$, $CaCO_3$, Ruß, Talkum, $Ca_2SiO_4$, $MgCO_3$ oder Glas ist.

**12.** Polyarylenthioetherformprodukt nach einem der vorhergehenden Ansprüche, dadurch **gekennzeichnet,** daß es weiterhin ein hochmolekulares organisches Füllmaterial enthält.

**13.** Polyarylenthioetherformprodukt nach Anspruch 12, dadurch **gekennzeichnet,** daß das hochmolekulare organische Füllstoffmaterial PE-Gummi, Polyisobutylen, hydriertes SBS-Gummi, Fluorgummi, Polyesterelastomer, Polyimid, Polyamid, Polyetheretherketon, Polysulfon, Polyethersulfon, Polyetherimid, Polyarylen, Polyphenylenether, Polycarbonat, Polyethylenterephthalat, Polybutylenterephthalat, Polyacetal, Polypropylen, Polyethylen, ABS, Polyvinylchlorid, Polymethylmethacrylat, Polystyrol, Polyvinylidenfluorid, Polytetrafluorethylen oder Tetrafluoroethylencopolymer ist.

**14.** Verwendung eines Polyarylenthioetherformproduktes nach einem der vorhergehenden Ansprüche als ein Verpackungsmaterial für ein elektronisches Teil.

**15.** Verwendung nach Anspruch 14, dadurch **gekennzeichnet,** daß das Polyarylenthioetherformprodukt eine Biegefestigkeit von nicht weniger als 12 $kg/mm^2$, eine Zugfestigkeit von nicht weniger als 7 $kg/mm^2$ und eine Izod-Stärke von nicht weniger als 8 kg x cm/cm aufweist.

**16.** Verwendung nach Anspruch 14 oder 15, dadurch **gekennzeichnet,** daß das elektronische Teil ein Kondensator, IC, LSI, Transistor oder Diodenelement ist.

**17.** Verwendung nach Anspruch 16, dadurch **gekennzeichnet,** daß das elektronische Teil ein Kondensatorelement ist.

Fig.1

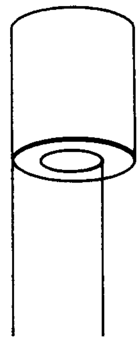

Fig.2

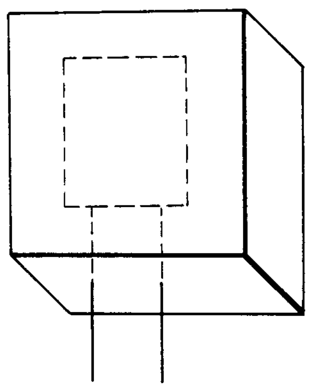

Fig.3